(19) **Europäisches Patentamt / European Patent Office / Office européen des brevets**

(11) **EP 2 287 757 A1**

(12) **EUROPEAN PATENT APPLICATION**

(43) Date of publication:
**23.02.2011 Bulletin 2011/08**

(51) Int Cl.:
***G06F 17/50*** (2006.01)

(21) Application number: **09168324.3**

(22) Date of filing: **20.08.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **FUJITSU LIMITED**
**Kawasaki-shi,**
**Kanagawa 211-8588 (JP)**

(72) Inventor: **Chow, Peter**
**Hayes, Middlesex UB4 8FE (GB)**

(74) Representative: **Wilding, Frances Ward**
**Haseltine Lake LLP**
**Lincoln House, 5th Floor**
**300 High Holborn**
**London WC1V 7JH (GB)**

(54) **Multilevel-Multigrid simulation techniques**

(57) A method for generating a multigrid domain for use in a simulation of wave propagation in a physical system, the method comprising generating a nested arrangement of embedded grids forming the multigrid domain by generating an initial grid having a selected time step and cell size, which initial grid is to be the finest grid in the multigrid domain, and iteratively performing the step of generating a coarser grid in which a grid generated in a previous iteration is to be embedded, starting with the initial grid, and ending with the generation of a base grid.

Stages 2 and 3

Coarse cell array in Y

Coarse cell array in X

Fig. 8

## Description

The present invention relates to a method and apparatus for generating a multigrid domain for use in a simulation of wave propagation in a physical system, and, particularly, to the simulation of electromagnetic fields using such a domain. The present invention finds particular, but not exclusive, application to the analysis of electromagnetic fields using the FDTD (Finite-Difference Time-Domain) technique to solve the Maxwell Equations and thus to simulate and forecast the dynamics of electromagnetic wave propagation for a given environment and conditions.

## Background

There is an ever increasing need to simulate and consider the effect of a wide variety of wave phenomena, such as electromagnetic wave propagation, arising in a variety of environments. Being able to simulate, for example, the dynamics of fluid propagation, heat transfer or electromagnetic radiation is highly advantageous in a number of industries. In particular, electromagnetic field simulation plays an important role in the design and development of electronic products. In this rapidly-changing technology, the time taken in bringing a product to the market place can be critical in maintaining a commercial advantage. In this regard, electromagnetic simulation can provide a highly advantageous tool for design engineers in advancing the development of a device. It may be used, for example, to approximate the surface currents and interior fields arising in complex electronic objects. Electromagnetic simulation is also employed to analyse the electromagnetic radiation emitted by electronic devices, particularly mobile communication devices, in order to assess the health and safety issues for these devices. Furthermore, the study of electromagnetic scattering plays a central role in the design of many complex structures, such as aircrafts, in order to optimise the design and shape of a structure surface. The simulation of convective heat transfer is a useful aid in the analysis and development of ventilation (cooling and/or heating) systems such as those employed in electronic devices. It also provides a tool suitable for use in fire simulation methods which seek to consider the potential fire hazards arising in the electronics industry and other industries.

Generally speaking, the main steps involved in any modelling process are:

1) To define the geometry of a system (i.e. structure or environment) under consideration on a structured grid, taking into account the need to impose boundary conditions on the finite grid as well as the material properties (e.g., for electromagnetic modelling, the magnetic permittivity $v$, the magnetic permeability $\mu$, and the electric conductivity $\sigma$ should be defined);

2) To calculate the numerical solutions for the physical phenomenon under consideration at each node within the grid at a given instant in time; and

3) To provide means for visualising and potentially manipulating the solutions obtained at each time step of the calculation.

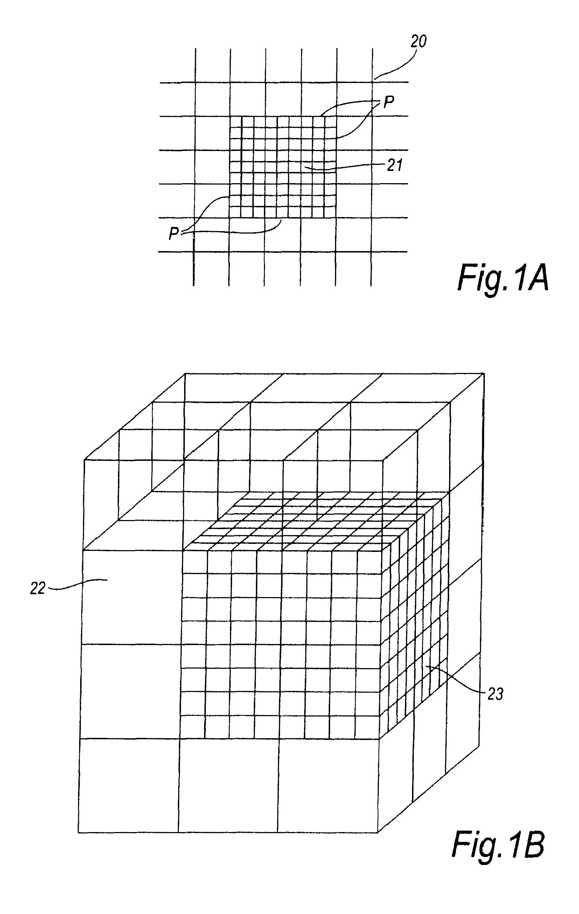

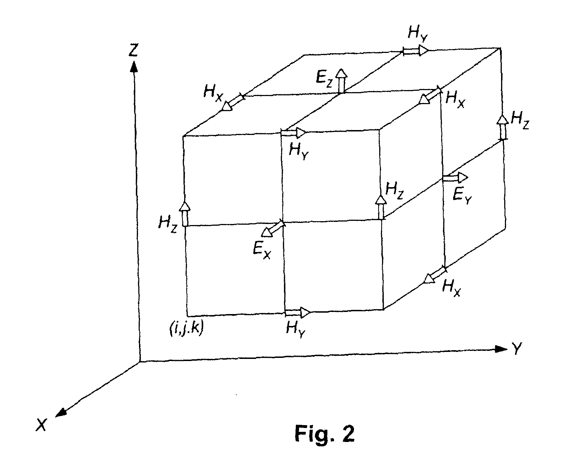

One scheme which finds use in such modelling methods is the FDTD scheme. It was first proposed by Yee in 1966 and is used in a number of computational simulation tools for analysing the behaviour of electromagnetic propagation within a one-, two-, or three-dimensional domain. Broadly speaking, the scheme employs a finite difference and finite time domain approach to discretise the differential form of Maxwell's equations. By this method, derivatives of the electric and magnetic field variables required by Maxwell's equations are approximated by spatial finite differences and the calculation then proceeds in a series of time steps. In accordance with the FDTD technique, the computational domain or space in which the simulation will be performed is represented by a Cartesian grid, discrete in both time and space, comprising a plurality of cells in one, two or three dimensions. Figures 1A and 1B show two- and three-dimensional grids respectively. Each of the cells comprises a number of solution points or nodes for the electric and magnetic fields at a given instant in time, as illustrated in Figure 2. In this illustration, the electric field components are defined on the cell faces and the magnetic field components are defined on the cell edges. In accordance with the FDTD principle, the electric field is staggered both spatially and temporally from the magnetic field.

As with any explicit numerical modelling technique, which employs a grid structure for the computational domain, there exists a restriction on the time step $\Delta t$ with respect to the cell size to ensure stability. Within the FDTD scheme this is given by:

$$\Delta t \le \left\langle \nu \sqrt{\frac{1}{\langle \Delta x \rangle^2} + \frac{1}{\langle \Delta y \rangle^2} + \frac{1}{\langle \Delta z \rangle^2}} \right\rangle^{-1}$$

where $\nu$ is the speed of light in free space. This stability condition, known as the Courant-Friedrichs-Lewy (CFL) condition, imposes a restriction on the size of the time step $\Delta t$ in relation to the cell dimensions of the grid.

In many instances, the object or environment to be modelled exhibits so-called inhomogeneities, such as complex or small-scale geometry, or curved boundaries. In order to accurately simulate and consider the effect of these inhomogeneities, the computational domain should preferably allow the numerical solution procedure to capture different levels of detail throughout the system. Analysing electromagnetic fields using a grid which cannot adequately resolve intricate or small-scale structures leads to an inaccurate simulation which, in many applications, can have critical consequences. Obtaining a model of insufficient accuracy is particularly unacceptable in applications where human safety is being investigated, for example analysing the effect of electromagnetic radiation from mobile communication devices on the human body. Furthermore, in complex multi-dimensional situations, for example when trying to simulate and forecast the electromagnetic dynamics for a complex object, such as a laptop computer, it is necessary to be able to resolve and precisely represent the electromagnetic interactions arising within the laptop at component level. Thus, it is apparent that the grid dimensions ($\Delta x$, $\Delta y$, $\Delta z$) employed in any gridded domain for simulation must be small enough to accurately represent the smallest feature in the model. Naturally, fine geometric features require fine grid cells for precise representation and thus, where a grid is employed throughout the domain in which $\Delta x = \Delta y = \Delta z$ for three dimensions, any spatial refinement needed to resolve small details leads to a global refinement of the computational grid dimensions. Similarly, the simulation of any wave phenomenon varying at a high frequency requires fine grid cells to represent accurately the propagation of the wave with time. If the object under consideration, or a part of it, is a small-scale or complex geometrical structure, such as a wire, it is clear that a fine grid is required accurately to model the field arising in the vicinity of the wire when an electric current is passed through the wire. Similarly, the errors that arise when modelling curved surfaces, due to the way in which they are 'staircased' to fit into the Cartesian grid, can be alleviated by employing a higher level of grid refinement.

Thus, to attain accuracy, fine grid cells are essential. An obvious consequence of the need to use fine grid cells in a uniform computational grid is an increase in the number of cells, and thus solution points, in the model. This in turn leads to a higher computing cost in terms of both memory and calculation time. In the example of FDTD schemes, the problem is further compounded by the CFL stability condition which bounds the time step $\Delta t$ in relation to the grid size so that the finer the grid cell, the smaller the time step $\Delta t$, thus further increasing the calculation workload. Software tools developed to analyse three-dimensional, highly intricate, high-frequency models therefore require substantial computing resources in the form of a large memory and high-processing-power central processing units to conduct a simulation that takes a considerable time to run.

Rather than dividing the entire computational domain into a grid of fine cells, it is known to employ a coarse grid globally over the domain and then to apply one or more fine grids, each fine grid having a plurality of fine-grid cells in regions where they are needed. A domain comprising a coarse grid and having an embedded fine grid is shown in Figures 1A and 1B. Figure 1A shows a two-dimensional coarse grid 20 which is uniformly refined by a fine grid 21 having nine cells for each cell of the coarse grid 20. Figure 1B shows a three-dimensional coarse grid 22 which is uniformly refined by a fine grid 23 having sixteen cells for each cell of the coarse grid 22. This technique, known as a subgridding or multigrid approach (the two terms are interchangeable), can therefore reduce the computational resource requirement by intelligently embedding fine grids locally in regions where they are needed within a coarse-grid model in order to resolve small-scale structures or to improve the modelling of curved boundaries. The savings in both memory and calculation time can be substantial, with the time taken to compute the solution being considerably faster than the uniform grid FDTD method by several orders of magnitude for three-dimensional models (even when compared with non-uniform grid FDTD, it is still few orders of magnitude faster), yet the technique substantially upholds the solution accuracy to that attained by a fine-grid model.

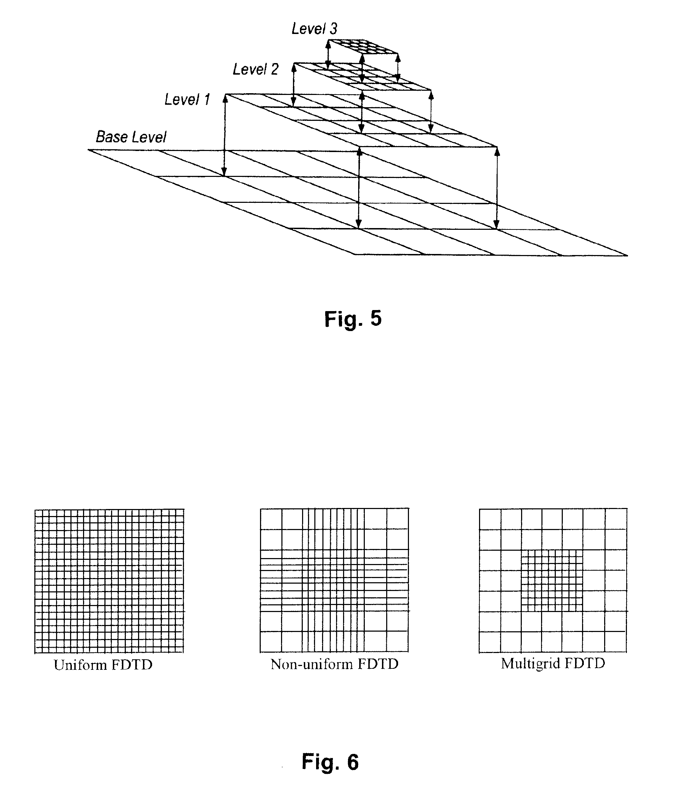

Presently, there is no known method of automatic mesh generation for analysis involving the multigrid-FDTD technique. Common practice is to automatically generate a base, coarse mesh (which may not be the coarsest mesh), which may be non-uniform, for the solution domain and to embed fine meshes in regions where they are required. This means the final mesh configuration, including the embedded meshes, is dependent on the initial, base mesh, i.e. the automatically generated coarse mesh for the FDTD scheme. Mesh embedding by such a method involves marking the regions in which to embed meshes based on the coarse mesh then subdividing the cells. A uniform base mesh may be generated automatically simply by calculating the largest cell size permissible and uniformly dividing the domain. While it is very fast, this approach is commonly resource inefficient in both memory and analysis time. A much more efficient approach is to generate a non-uniform base mesh, which distributes the mesh cells more smartly where they are required in each of the dimensions. Figure 6 shows the kinds of mesh used in FDTD schemes, i.e. a uniform FDTD mesh, a non-uniform FDTD mesh, and a multigrid FDTD mesh. Generally, a non-uniform mesh needs to conform to a cell-aspect-ratio of two or less for the FDTD method, otherwise it can affect the solution accuracy. Still, automatic non-uniform mesh generation is possible but a little more complicated compared to uniform mesh generation.

Existing automatic mesh generation tools for FDTD are forced to generate meshes that satisfy the CFL condition, as otherwise the stability of the FDTD solution cannot be guaranteed. This frequently results in a small time step increment due to geometric features in the domain, such as small objects or objects located close together which define a small gap and which cannot be combined. However, it is advantageous to have as large a time step increment as possible in order to reduce the number of time steps for the transient calculations and to provide for faster analysis.

It is also desirable to provide a stable multigrid-FDTD solution that has no late-time instability.

**Summary**

A first aspect provides a method for generating a multigrid domain for use in a simulation of wave propagation in a physical system, the method comprising
generating a nested arrangement of embedded grids forming the multigrid domain by generating an initial grid having a selected time step and cell size, which initial grid is to be the finest grid in the multigrid domain, and iteratively performing the step of generating a coarser grid in which a grid generated in a previous iteration is to be embedded, starting with the initial grid, and ending with the generation of a base grid.

The method may provide a new, automatic mesh and embedded mesh generation technique for multigrid-FDTD schemes that can generate optimal meshes in order to achieve maximum performance. Unlike previous automatic mesh generation techniques for FDTD, where only the spatial space information is required to generate meshes, the new method can use both spatial and temporal spaces information to automatically generate the required meshes. The final mesh configuration can be based on the optimal time step increment permissible from the start for use with embedded meshes, with the time step for coarser grids being derived ultimately from the time step for the initial grid. The generated mesh configuration is thus close to optimal, if not optimal, for multigrid-FDTD technology, for example for use in electromagnetic wave propagation simulation and analysis.

In contrast, in the previous mesh generations methods, in which the base mesh is generated with technology designed for FDTD and not multigrid-FDTD, the base mesh has the optimal time step increment permissible. Therefore, any embedding only reduces the time step increment based on the embedded mesh refinement value, which reduces the performance possible with Multigrid-FDTD technology, and does not result in an optimised mesh configuration in both spatial and temporal spaces. Such mesh generation technology omits temporal space when generating meshes. This is useful with technology such as multigrid-FDTD that aims to exploit the temporal space to achieve enhanced performance. Naturally, optimal performance can only be achieved when the mesh configuration is also optimal.

The method may be particularly useful owing to the development of stable embedded grid technology for FDTD in both spatial and temporal spaces.

The multigrid domain may be used in a multigrid FDTD simulation, which may be computer-implemented. The simulation may be the simulation of an electromagnetic field or electromagnetic waves. An object to be simulated may be an electrical, electronic or photonic object, for example. The method may comprise defining a computational domain including the multigrid domain. The computational domain may comprise a Cartesian-type grid. The computational domain may be created by means of a computer program run on a computer. Input data representing the system geometry and material properties may be entered by a user.

Furthermore, an update procedure necessary to undertake the simulation may be carried out, e.g. by means of a computer program installed and run on a computer. The simulation may involve the assessment of wave propagation arising in a physical system by obtaining a numerical approximation of the physical system to be simulated. Each cell in the domain may comprise one or more solution points at which values representing a physical quantity of the physical system to be simulated may be obtained. The update procedure may be performed to obtain a value for at least one solution point of every cell at a given stage in time.

For example, when the method is employed for the numerical approximation of an electromagnetic field based on a FDTD (Finite-Difference Time-Domain) method, each cell may hold an arrangement of solution points for the electromagnetic field in which the solution points for the electric field ($\vec{E}$) are staggered orthogonally with respect to the solution points of the magnetic field ($\vec{H}$). The update procedure may be performed to obtain solutions for the electric and magnetic fields using the FDTD updating equations which define a new value of a first-field component (where the first-field component is one of E or H) at a given instant in time and point in space in relation to a gradient term of a second-field component (where the second field component is the other of E and H) at the given point in space of the first-field component. The gradient term can be approximated by the difference between the value of the second-field component on one side of the given point in space of the first-field component and the value of the second-field component on an opposite side of the given point in space of the first-field component.

The method may comprise the generation of uniform and/or non-uniform meshes, in one, two or three dimensions. It is to be understood that the terms "mesh" and "grid", and their derivatives, are used herein interchangeably.

By "nested" is meant an arrangement of grids in which one grid is embedded within another, which is preferably embedded in another, and so on. It should be appreciated that a domain having several levels of refinement is envisaged in which a fine grid having a higher level of refinement may be embedded within a fine grid having a lower level of refinement. Thus, in situations where significant refinement of a coarse grid is needed in order to resolve a particular feature or source of inhomogeneity, the required level of refinement can be achieved in a series of refinement stages. In this way, the discontinuity between the coarse grid and the ultimate grid of the required refinement level is more gradually introduced bringing a greater level of stability to the calculation procedure. Thus, grids may be positioned within the computational domain so as to map inhomogeneities arising in the physical system to be simulated.

By "finest grid" is meant the grid in the multigrid domain having the smallest cells, e.g. the smallest mean cell size for a non-uniform grid, and consequently the smallest time step (based on the CFL condition).

By "coarser grid" is meant a grid which has a cell size (e.g. a mean cell size) which is larger than that of the grid which is embedded in it. In other words, the embedded grid refines or is a refinement of the coarser grid.

By "refinement factor" is meant the whole number by which a cell has been divided in one of the x, y, and z directions. Alternatively, it may be defined as the ratio between the size of a coarser cell in one of the x, y and z directions and the size (in the same direction) of a finer cell which is a refinement of the coarser cell. It is to be understood from the use of the terms "coarser" and "finer" that the terms apply as a means of distinguishing two grids from one another. When a three-dimensional cell is refined, there may be three different refinement factors, one for each of the x, y and z directions. These refinement factors may be labelled $k_x$, $k_y$ and $k_z$, for example.

By "base grid" is meant the grid in the multigrid domain which is embedded in no other grid. In other words, all other grids of the domain are embedded directly or indirectly in the base grid. The base grid may extend throughout the computational domain.

The operation of generating a grid may comprise any one or more of the following actions: determining its location relative to the object to be simulated; setting its boundaries; determining its cell size and time step; creating lines to define its cell spacing; positioning lines within region in which grid is to exist. The grid generated may be a uniform grid or a non-uniform grid.

The operation of embedding a grid may comprise any one or more of the following actions: positioning a finer grid (embedded grid) overlaying a coarser grid, with at least part of the finer grid overlaying the coarser grid; assigning smaller cells to the finer grid than to the coarser grid; preferably embedding the finer grid such that an integer number of cells of the finer grid fit within a cell of the coarser grid, i.e. using an integer refinement factor; positioning lines of the finer grid preferably to lie along lines of the coarser grid.

The method may comprise identifying regions of the domain in which to embed each grid of the multigrid domain, all or part of one or more of the regions being aligned with one or more geometric features of an object to be simulated.

By "aligned" it is meant that, for example, a boundary or a part of the boundary of the region lies contiguously with a line defining an edge or an internal feature of the object, or that the part of the boundary is an extension of a line defining the edge or an internal feature of the object, and continuing in the same direction Alternatively, the boundary or part of the boundary may lie parallel with, or perpendicular to, a line defining an edge or an internal feature of the object.

There may be at least one region covering the entirety of the object. Further regions may cover geometric features of interest of the object, for example relatively small or detailed features, or features which are important to the function of the object. In particular, the finest grid of the multigrid domain may be arranged to cover the smallest geometric feature of the object. Coarser grids may be overlaid at least partially by finer grids and surround the smallest geometric feature, extending further outwards from the feature than the finer grid. Any one or more of the regions and the grids embedded therein may be non-regular in shape.

Selecting the time step and cell size for the initial grid may comprise making the selection based on geometric features of the object to be simulated, in particular the smallest geometric feature of the object. The method may comprise using a stability condition (which may be the CFL condition) to calculate a largest permissible time step for a cell the size of the smallest geometric feature. Or, the method may comprise selecting the time step and the cell size for the initial grid based on the largest time step permissible for the region identified for that grid. In one arrangement, the smallest geometric feature of the object is identified and enclosed by a cell in a coarse cell array (CC array), and the largest time step permissible (calculated from the CFL condition) is used for that cell and surrounding cells in an embedded region. The method of selection may be known to the skilled person, and may take into account user specifications regarding the refinement factor.

The method may comprise, during each iteration, comparing a size of a smallest cell in a said grid generated in the current iteration with a size or sizes of other cells in the multigrid domain, and, when predetermined similarity criteria are met, stopping the iteration process, for example by generating the base grid in the next iteration. The size or sizes of the other cells may be represented by an average or largest cell size for the domain.

In one embodiment (and in particular when there has been refinement in the dimension concerned) the method may comprise comparing a size of a cell resulting from the combination of cells in the current or a said previous iteration with a size of at least one other cell in the multigrid domain.

By "size" it may be meant an area of a cell, or a width in one dimension or in another dimension, for example the size of a cell in a coarse cell array, to be described later. The average cell size may be a mean of such values taken over a number of cells, being for example a sample of cells or all of the cells in the domain.

The determination of whether or not the sizes meet the predetermined similarity criteria may comprise the comparison of the difference between or ratio between the size of the smallest cell and the average or largest cell size for the domain with a user-defined or predetermined parameter. If the difference is less or ratio is larger than the user-defined or predetermined parameter, it may be ascertained that the sizes meet predetermined similarity criteria. This operation may be performed for each dimension. An alternative approach is to make a similar comparison but based on time steps rather than cell sizes. The two approaches are interchangeable.

Further, a simple alternative is only to allow further cell combination in the refinement process if the combination of the smallest cell and its neighbouring cell with which it is combined is still smaller in size than the average or largest other cell size in the cc array.

The method may comprise embedding a said grid in the region of the respective coarser grid identified for the said grid, and in cells of the coarser grid immediately surrounding the identified region.

The method may comprise:-

(i) analysing geometric features of an object to be simulated;
(ii) identifying a region in which to locate the initial grid of the multigrid domain based on the geometric features of the object;
(iii) selecting the time step and the cell size of the initial grid;
(iv) based on the geometric features of the object, identifying a region in which to locate a said coarser grid in which the initial grid is to be embedded, the initial grid being a refinement of the said coarser grid according to a selected refinement factor;
(v) calculating a time step and a cell size of the coarser grid based on the time step and the cell size of the initial grid and the refinement factor;
(vi) repeating steps (iv) and (v) for any further said coarser grids in which a said coarser grid of a previous iteration is to be embedded, until the base grid is identified, which is not to be embedded in any other grid;
(vii) embedding each grid to be embedded in the identified region of a respective said coarser grid, to generate the nested arrangement of embedded grids forming the multigrid domain.

A second aspect provides an apparatus for generating a multigrid domain for use in a simulation of wave propagation in a physical system, the apparatus comprising
generation circuitry configured to generate a nested arrangement of embedded grids forming the multigrid domain by generating an initial grid having a selected time step and cell size, which initial grid is to be the finest grid in the multigrid domain, and iteratively performing the operation of generating a coarser grid in which a grid generated in a previous iteration is to be embedded, starting with the initial grid, and ending with the generation of a base grid.

The generation circuitry may be configured to identify regions of the domain in which to embed each grid of the multigrid domain, all or part of one or more of the regions being aligned with one or more geometric features of an object to be simulated.

The generation circuitry may be configured to select the time step and the cell size for the initial grid based on the largest time step permissible for the region identified for that grid.

The generation circuitry may be configured, during each iteration to compare a size of a smallest cell in a said grid generated in the current iteration with a size orsizes of other cells in the multigrid domain, and, when the sizes meet predetermined similarity criteria, to stop the iteration process, for example by generating the base grid in the next iteration. The sizes of other cells in the multigrid domain may be represented by an average cell size for the domain. Alternatively, comparison against the largest cell size may be made.

In one alternative, the generation circuitry may be configured, during each iteration to compare the size of the combination of the smallest cell size (from a previous iteration) with its neighbouring cell in said grid (which combination is generated in the current iteration) against sizes of at least one other cell in the multigrid domain and, when the combination size is equal to or larger than the size of the at least one other cell, to terminate the iterations, for example by generating the base grid in the next iteration. As before, the comparison may be against a largest cell size or an average cell size. The generation circuitry may be configured to embed a said grid in the region of the respective coarser grid identified for the said grid, and in cells of the coarser grid immediately surrounding the identified region.

The generation circuitry may be configured to

(i) analyse geometric features of an object to be simulated;
(ii) identify a region in which to locate the initial grid of the multigrid domain based on the geometric features of the object;
(iii) select the time step and the cell size of the initial grid;
(iv) based on the geometric features of the object, identify a region in which to locate a said coarser grid in which the initial grid is to be embedded, the initial grid being a refinement of the said coarser grid according to a selected refinement factor;
(v) calculate a time step and a cell size of the coarser grid based on the time step and the cell size of the initial grid and the refinement factor;
(vi) repeat operations (iv) and (v) for any further said coarser grids in which a said coarser grid of a previous iteration is to be embedded, until the base grid is identified, which is not to be embedded in any other grid;
(vii) embed each grid to be embedded in the identified region of a respective said coarser grid, to generate the nested arrangement of embedded grids forming the multigrid domain.

A third aspect provides a computer program which, when executed on a computer, causes the computer to perform the method of the first aspect.
A fourth aspect provides a computer program which, when executed on a computer, causes the computer to become the apparatus of the second aspect.
The computer program of the third or fourth aspect may be carried by a carrier medium. The carrier medium may be a recording medium. The carrier medium may be a transmission medium.
Another aspect provides a method (and corresponding apparatus) for generating a multigrid domain for use in a simulation of wave propagation in a physical system, the method comprising

selecting a time step for a finest grid of the multigrid domain;
analysing geometric features of an object to be simulated and identifying regions in which to locate the finest grid and one or more levels of coarser grids, including a base grid, wherein a time step for each coarser grid and for the base grid is a multiple of the selected time step for the finest grid according to refinement factors;
starting from the base grid, embedding any coarser grids and the finest grid in the identified regions in the grids in which they are to be embedded.

The invention includes one or more aspects, embodiments or features in isolation or in various combinations whether or not specifically stated (including claimed) in that combination or in isolation.
The above summary is intended to be merely exemplary and non-limiting.

**Brief Description Of The Drawings**

For a better understanding of the present invention, and to show how the same may be carried into effect, reference will now be made, by way of example, to the accompanying drawings in which:

Figures 1A and 1B show the application of an embedded fine grid to a computational domain illustrated in two and three dimensions respectively;

Figure 2 shows a three-dimensional cell employed in a FDTD (Finite-Difference Time-Domain) scheme;

Figure 3 illustrates a simulated electromagnetic wave propagating from a central source point;

Figure 4A shows an application of a fine grid to a signal line structure and Figure 4B shows the application of a fine-grid region comprising a number of fine grids to the signal line structure;

Figure 5 shows a multi-grid domain having base level and first, second and third level grids each having uniform cells;

Figure 6 shows uniform, non-uniform and multigrid grid systems in an FDTD scheme;

Figure 7 shows a mesh mapped to the geometric features of an object to be modelled according to one example of automatic mesh generation;

Figure 8 shows the mesh of Figure 7 during a mesh embedding process;

Figure 9 shows a minimum FDTD mesh involving mesh lines positioned relative to an object to be modelled according to another example of automatic mesh generation;

Figure 10 shows the minimum mesh of Figure 9 at a later stage of the automatic mesh generation process;

Figure 11 shows the minimum mesh of Figure 10 after updating of the coarse cell arrays;

Figure 12 shows the mesh of Figure 11 after a first stage of a second iteration of the automatic mesh generation process;

Figure 13 shows the mesh of Figure 12 during a later stage of the second iteration of the automatic mesh generation process;

Figure 14 shows the mesh of Figure 13 after updating of the coarse cell arrays;

Figure 15 shows an initial FDTD mesh based on the mesh of Figure 14;

Figure 16 shows the mesh of Figure 15 during a first level of grid embedding;

Figure 17 shows the mesh of Figure 16 after the first level of grid embedding;

Figure 18 shows the mesh of Figure 17 during a second level of grid embedding;

Figure 19 shows the mesh of Figure 18 after the second level of grid embedding;

Figure 20 shows an FDTD mesh according a comparative example;

Figure 21 shows the mesh of Figure 20 after grid embedding;

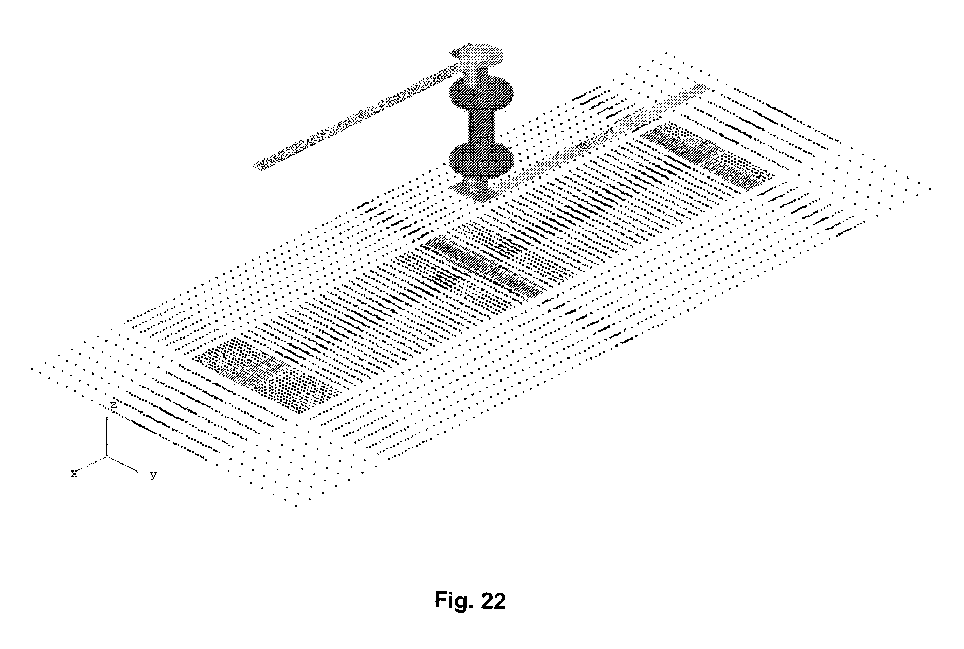

Figure 22 shows a 3D model of a via to be simulated using an FDTD scheme;

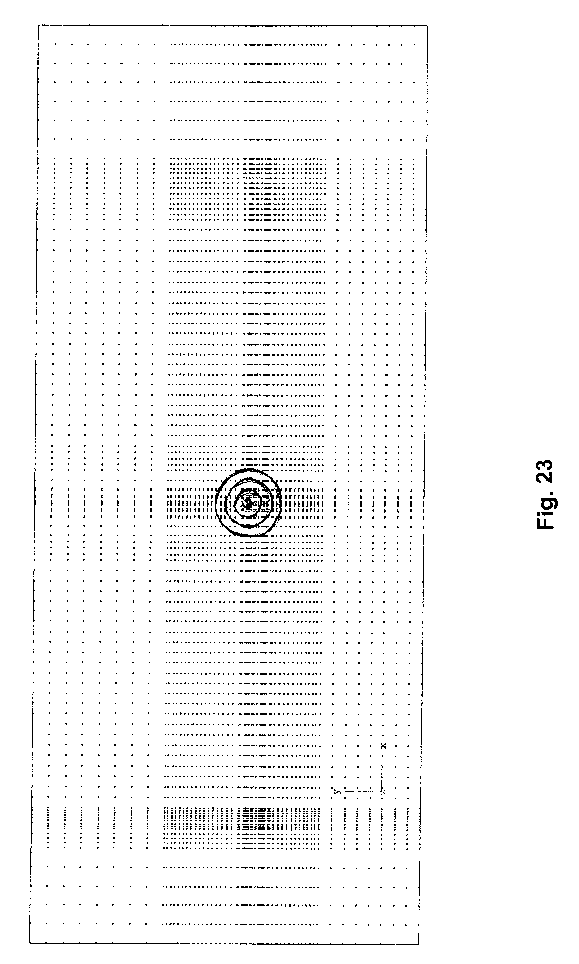

Figure 23 shows a mesh positioned around the via using the method described herein;

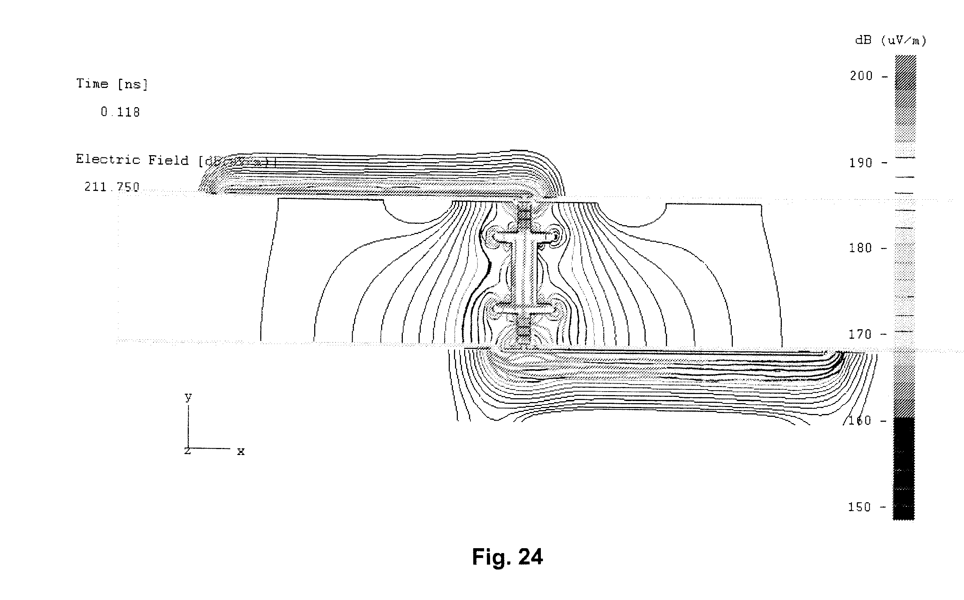

Figure 24 shows contour lines representing an electromagnetic field developed during the simulation of the via of Figure 22, using the mesh of Figure 23;

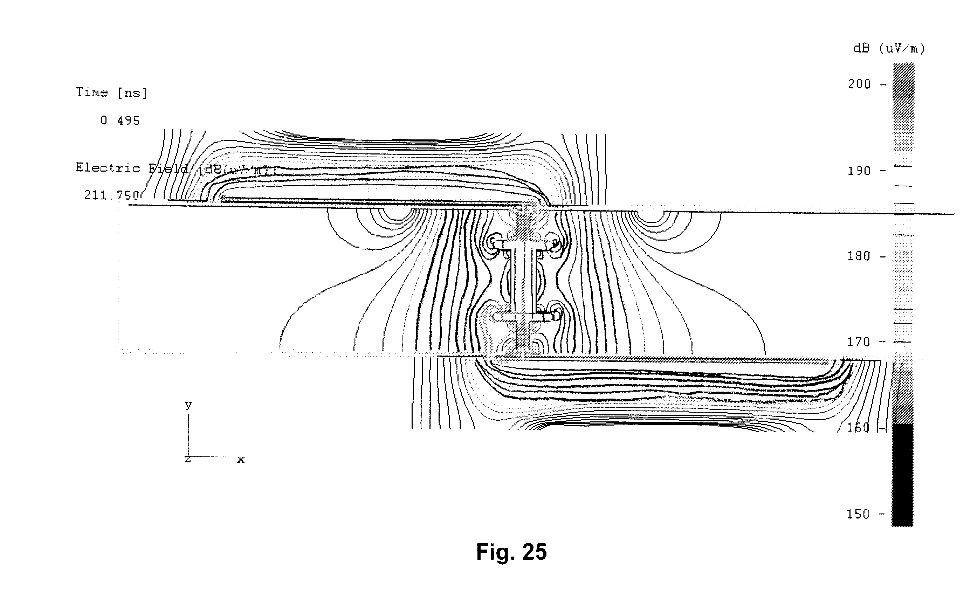

Figure 25 shows the contour lines as in Figure 24 at a later stage of the simulation;

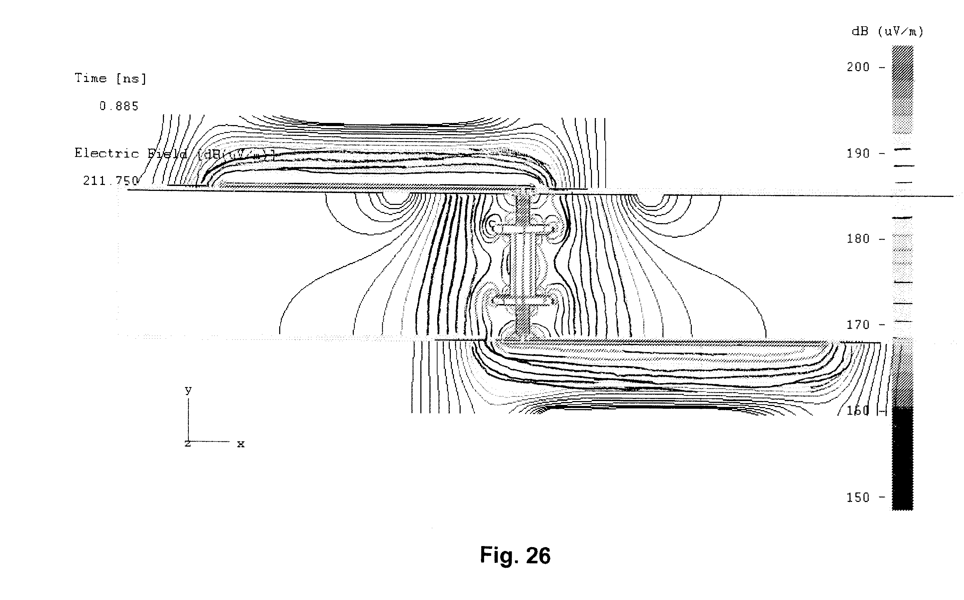

Figure 26 shows the contour lines as in Figure 25 at a still later stage of the simulation.

**Detailed Description**

The following background theory relating to the FDTD scheme for simulating electromagnetic radiation is considered useful to aid the understanding of the present invention.

Figure 1A shows, in two dimensions, part of a computational domain comprising a coarse grid 20 and a fine grid 21 embedded therein. The perimeter P of the fine grid, which is embedded within an area of nine coarse-grid cells, forms the interface between the coarse grid and the fine grid. Figure 1B shows, in three dimensions, part of a computational domain comprising a coarse grid 22 and a fine grid 23 embedded therein.

Each of the cells comprises a number of solution points for the numerical approximation which are solved at a given instant in time. Thus, the picture simulated from the mathematical solutions on the grid is representative of the physical system being simulated at a given instant in time n.

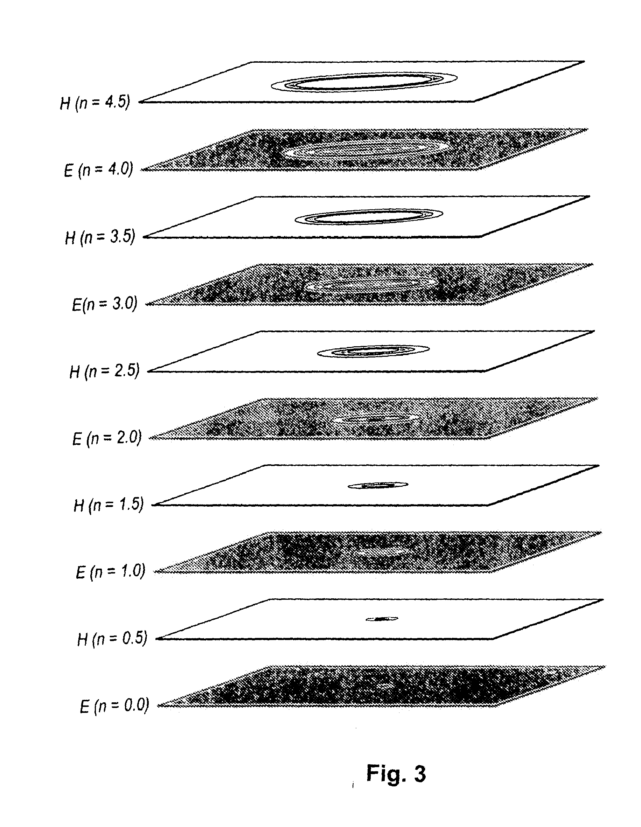

Figure 2 shows a three-dimensional cell wherein each point of the cell is represented by integers (i, j, k), where i, j and k are grid coordinate numbers in the x, y and z directions respectively. The cell comprises a number of solution points or nodes for the electric and magnetic fields at a given instant in time. In this illustration, the electric field components are defined on the cell faces and the magnetic field components are defined on the cell edges. In accordance with the FDTD principle, the electric field solution points are staggered both spatially and temporally from the magnetic field solution points. This means that no solution is obtained for both the electric and magnetic field at the same instant in time or at the same position in space. Rather, the electric field is solved at a given instant in time, say n = 0, 1, 2... and the magnetic field is solved at the next instant in time, say n = 0.5, 1.5, 2.5.... This is illustrated pictorially in Figure 3, which shows a simple electromagnetic wave propagating from a central source point, where the initial field conditions are zero at all points in space.

In order to update the values at each of the solution points, an explicit time-marching solution procedure is carried out in which solutions are obtained at a given instant in time with reference to values at the previous instant in time. Solutions are firstly obtained in this way for the coarse grid. During the update procedure, and in order to update the solution points of each of the fine-grids, the fine-grid values at each common interface within the fine grid may be obtained from the coarse-grid solution at that common interface by means of spatial and temporal interpolation.

Any electromagnetic field is fully described by the Maxwell equations:

$$(1) \quad \nabla \cdot \vec{E} = 0$$

$$(2) \quad \nabla \cdot \vec{H} = 0$$

$$(3) \quad \mu \frac{\partial \vec{H}}{\partial t} = \nabla \times \vec{E}$$

$$(4) \quad \varepsilon \frac{\partial \vec{E}}{\partial t} + \sigma \vec{E} = \nabla \times \vec{H}$$

where E = (Ex, Ey, Ez) is the electric field (V/m), H = (Hx, Hy, Hz) is the magnetic field (A/m), $\nu$ is the magnetic permittivity (F/m), $\mu$ is the magnetic permeability (H/m) and $\sigma$ is the electric conductivity (S/m).

Writing equations (3) and (4) in component form gives:

$$(5) \quad \mu \frac{\partial H_x}{\partial t} = \frac{\partial E_y}{\partial z} - \frac{\partial E_z}{\partial y}$$

$$(6) \quad \mu \frac{\partial H_y}{\partial t} = \frac{\partial E_z}{\partial x} - \frac{\partial E_x}{\partial z}$$

$$(7) \quad \mu \frac{\partial H_z}{\partial t} = \frac{\partial E_x}{\partial y} - \frac{\partial E_y}{\partial x}$$

$$(8) \quad \varepsilon \frac{\partial E_x}{\partial t} + \sigma E_x = \frac{\partial H_z}{\partial y} - \frac{\partial H_y}{\partial z}$$

$$(9) \quad \varepsilon \frac{\partial E_y}{\partial t} + \sigma E_y = \frac{\partial H_x}{\partial z} - \frac{\partial H_z}{\partial x}$$

$$(10) \quad \varepsilon \frac{\partial E_z}{\partial t} + \sigma E_z = \frac{\partial H_y}{\partial x} - \frac{\partial H_x}{\partial y}$$

It can be seen from equation (3) that the time derivative of the H field is dependent on the Curl of the E field (i.e. the change in the E field across space). Similarly from equation (4), the time derivative of the E field is dependent on the change in the H field across space. This leads us to the basic FDTD expression that the new value of the E-field $E^{N+1}$ at a given point in space is dependent on i) the old value of the E-field $E^N$ at the same point in space and ii) the difference between the old value of the H-field, $H^{N+1/2}$, on one side of the E-field point in space and the value of $H^{N+1/2}$ on another side of the E-field point in space. Similarly, the new value of the H-field is dependent on the old value of the H-field and the difference between the old values for the E-field on either side of the H-field point. Thus, approximating the spatial derivatives of equations (5) to (10) gives the following FDTD central-difference updating stencils for the electromagnetic field:

$$(11) \quad H_x^{n+1/2}(i, j+\tfrac{1}{2}, k+\tfrac{1}{2}) = H_x^{n-1/2}(i, j+\tfrac{1}{2}, k+\tfrac{1}{2}) + D_b(i, j+\tfrac{1}{2}, k+\tfrac{1}{2})$$

$$\left[ \; \left\{ E_y^n(i, j+\tfrac{1}{2}, k+1) - E_y^n(i, j+\tfrac{1}{2}, k) \right\} / \Delta z(k) \right.$$
$$\left. - \left\{ E_z^n(i, j+1, k+\tfrac{1}{2}) - E_z^n(i, j, k+\tfrac{1}{2}) \right\} / \Delta y(j) \; \right]$$

$$(12) \quad H_y^{n+1/2}(i, +\tfrac{1}{2}, j, k+\tfrac{1}{2}) = H_y^{n-1/2}(i+\tfrac{1}{2}, j, k+\tfrac{1}{2}) + D_b(i+\tfrac{1}{2}, j, k+\tfrac{1}{2})$$

$$\left[ \; \left\{ E_z^n(i+1, j, k+\tfrac{1}{2}) - E_z^n(i, j, k+\tfrac{1}{2}) \right\} / \Delta x(i) \right.$$
$$\left. - \left\{ E_x^n(i+\tfrac{1}{2}, j, k+1) - E_x^n(i+\tfrac{1}{2}, j, k) \right\} / \Delta z(k) \; \right]$$

$$(13) \quad H_z^{n+1/2}(i+\tfrac{1}{2}, j+\tfrac{1}{2}, k) = H_z^{n-1/2}(i+\tfrac{1}{2}, j+\tfrac{1}{2}, k) + D_b(i+\tfrac{1}{2}, j+\tfrac{1}{2}, k)$$

$$\left[ \left\{ E_x^n(i+\tfrac{1}{2}, j+1, k) - E_x^n(i+\tfrac{1}{2}, j, k) \right\} / \Delta y(j) \right.$$
$$\left. - \left\{ E_y^n(i+1, j+\tfrac{1}{2}, k) - E_y^n(i, j+\tfrac{1}{2}, k) \right\} / \Delta x(i) \right]$$

$$(14) \quad E_x^{n+1}(i+\tfrac{1}{2},j,k) = C_a(i+\tfrac{1}{2},j,k)\cdot E_x^n(i+\tfrac{1}{2},j,k) + C_b(i+\tfrac{1}{2},j,k)$$

$$[\{H_z^{n+1/2}(i+\tfrac{1}{2},j+\tfrac{1}{2},k) - H_z^{n+1/2}(i+\tfrac{1}{2},j-\tfrac{1}{2},k)\}/\Delta y(j)$$

$$-\{H_y^{n+1/2}(i+\tfrac{1}{2},j,k+\tfrac{1}{2}) - H_y^{n+1/2}(i+\tfrac{1}{2},j,k-\tfrac{1}{2})\}/\Delta z(k)]$$

$$(15) \quad E_y^{n+1}(i,j+\tfrac{1}{2},k) = C_a(i,j+\tfrac{1}{2},k)\cdot E_y^n(i,j+\tfrac{1}{2},k) + C_b(i,j+\tfrac{1}{2},k)$$

$$[\{H_x^{n+1/2}(i,j+\tfrac{1}{2},k+\tfrac{1}{2}) - H_x^{n+1/2}(i,j+\tfrac{1}{2},k-\tfrac{1}{2})\}/\Delta z(k)$$

$$-\{H_z^{n+1/2}(i+\tfrac{1}{2},j+\tfrac{1}{2},k) - H_z^{n+1/2}(i-\tfrac{1}{2},j+\tfrac{1}{2},k)\}/\Delta x(i)]$$

$$(16) \quad E_z^{n+1}(i,j,k+\tfrac{1}{2}) = C_a(i,j,k+\tfrac{1}{2})\cdot E_z^n(i,j,k+\tfrac{1}{2}) + C_b(i,j,k+\tfrac{1}{2})$$

$$[\{H_y^{n+1/2}(i+\tfrac{1}{2},j,k+\tfrac{1}{2}) - H_y^{n+1/2}(i-\tfrac{1}{2},j,k+\tfrac{1}{2})\}/\Delta x(i)$$

$$-\{H_x^{n+1/2}(i,j+\tfrac{1}{2},k+\tfrac{1}{2}) - H_x^{n+1/2}(i,j-\tfrac{1}{2},k+\tfrac{1}{2})\}/\Delta y(j)]$$

where

$$D_b(i,j,k) = \frac{\Delta t}{\mu(i,j,k)}$$

$$C_a(i,j,k) = \frac{2\varepsilon(i,j,k) - \sigma(i,j,k)\Delta t}{2\varepsilon(i,j,k) + \sigma(i,j,k)\Delta t}$$

$$C_b(i,j,k) = \frac{2\Delta t}{2\varepsilon(i,j,k) + \sigma(i,j,k)\Delta t}$$

During the computational simulation, equations (11) to (16) are solved in a leap-frog manner to incrementally advance the E and H fields forward in time by a time step $\Delta t$.

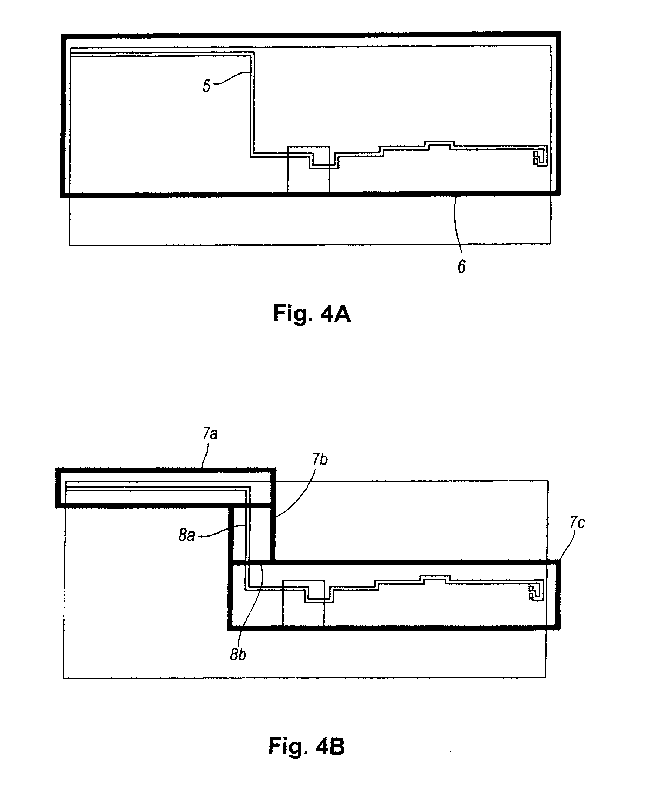

Figure 4A shows a signal line structure 5 for which a model of the electromagnetic radiation arising in the vicinity of the signal line is required. A large fine grid 6 is applied to the domain required to obtain the numerical approximation of the signal line structure. It can be seen that there are significant areas of the domain which do not contain features requiring the higher level of refinement but which will require the computational resources of a fine grid to process. Figure 4B illustrates the way in which a plurality of fine grids 7a, 7b and 7c can be positioned within a computational domain so as to substantially map the geometrical outline of the signal line. Intelligently positioning a fine-grid region comprising a plurality of fine grids allows a source of inhomogeneity arising in a system to be efficiently processed and resolved.

The domain in which the simulation is to be performed is normally created by means of a computer program implemented on a computer. The geometry of the system to be simulated must be specified pre-processing by a user, together with details of the initial field conditions (which may be zero), a function representing at least one source of electromagnetic radiation and the material properties (e.g. the magnetic permittivity v, the magnetic permeability μ, and the electric conductivity σ may be defined). Furthermore, in order to produce an accurate solution to Maxwell's equations, the results should represent a solution over an infinite space. However, practical limitations of computer power and memory require the termination of the computational grid. Any such termination method must not affect the computations inside the finite computational grid. Thus, boundary conditions to this effect are imposed on the computational domain boundaries before the simulation is performed. Due to the explicitness of the FDTD method, Dirichlet (fixed value) interface boundary conditions are the most appropriate for the embedded fine grid boundary.

In the case in which fine-grid regions, possibly of varying refinement levels, are positioned within the domain so as to map the geometrical outline of, for example, small-scale structures or curved boundaries, a user may specify the position, refinement level and boundary perimeter of each fine grid making up the fine-grid region, together with its connectivity to other fine grids within the fine-grid region. Figure 5 shows a multigrid-FDTD scheme including a base level mesh, and first, second and third level embedded grids, with each embedded grid being a refinement of its predecessor.

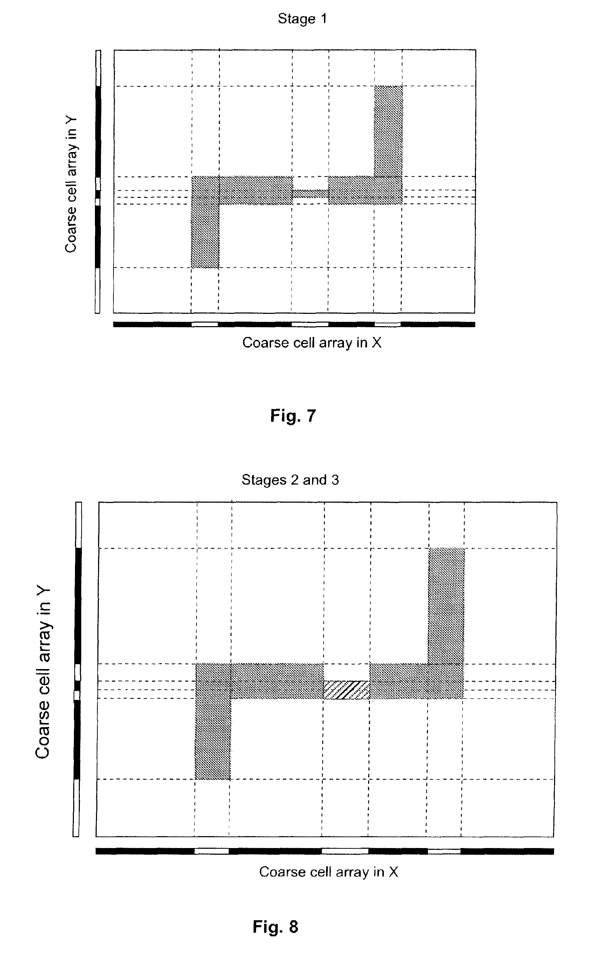

Figures 7-21 relate to a method for automatic mesh and embedded mesh generation.

One example of the method involves a five-step approach, which will now be summarised, with reference to Figures 7 and 8.

In the first step (stage 1), the geometric features for each dimension are calculated and the smallest cell in the domain identified. This step is the same for both uniform and non-uniform schemes. The geometric features for each dimension are referred to as the coarsest cell (CC) array. Figure 7 shows the geometric features and the CC array in each dimension X and Y in a two-dimensional example. The calculation of geometric features in this step may be performed according to methods known to the skilled person, and so no further description of this step will be given.

In stage 2, with the smallest cell identified from stage 1, the mesh embedding begins. The largest time step increment permissible (calculated from the CFL condition) is used for the smallest cell and surrounding cells in the embedded region. Figure 8 shows the mesh after the process of mesh embedding and updating of the CC arrays (stages 3 and 4).

In stage 3, the embedded mesh is generated and an association to the parent (coarse) mesh created.

In stage 4, the CC array is updated in each of the dimensions. This means the cell size of the embedded region has changed dependent on the refinement value. In many cases, updating leads to the combination of neighbouring cells. However, there may be no refinement in one or more dimensions, so that updating leads to no change in cell size.

In stage 5, the smallest cell size in the updated CC arrays is calculated to attend to comparison with the largest permissible time step increment value. The whole domain (each of the CC arrays) is checked for the smallest cell size, because the next smallest geographical feature may be located away from the previous region of the smallest cells. However, the smallest cell found in stage 5 may often be the cell corresponding to the combination made in stage 4 of the previous smallest cell and its neighbour.

Further, for comparison, the mean cell size for the entire domain is calculated, along with its time step increment value. Alternatively, the largest cell size may be used. In one suitable process, at least one of the updated cell size and average/largest cell size values is compared with an associated user-defined parameter. For example, the parameter may be a ratio between the updated cell size and average/largest cell size values. The method stops if the value/ratio is close to the user-defined parameter. In another suitable process, the method stops if the updated size of the previously smallest cell is greater than or equal to the largest or average cell size. Otherwise, the method repeats from the identification of the smallest cell in stage 1 onwards.

In this way, CC arrays updated during each iteration provide a construct for the embedding of grids to map the smaller features of the object. In each iteration, it is determined whether the method should be repeated. For instance, the smallest cell may be identified by its dimensions, and a determination made as to whether the smallest cell can be further combined in a subsequent iteration or whether it is sufficiently similar to the average or largest cell size for the method to stop.

The invention may provide a new, automatic mesh and embedded mesh generation technique for multigrid-FDTD schemes that can generate optimal meshes in order to achieve maximum performance. Unlike previous automatic mesh generation techniques for FDTD, where only the spatial space information is required to generate meshes, the new method uses both spatial and temporal space information to automatically generate the required meshes, with the final mesh configuration being based on the optimal time step increment permissible from the start for use with embedded meshes. The generated mesh configuration is thus close to optimal, if not optimal, for multigrid-FDTD technology.

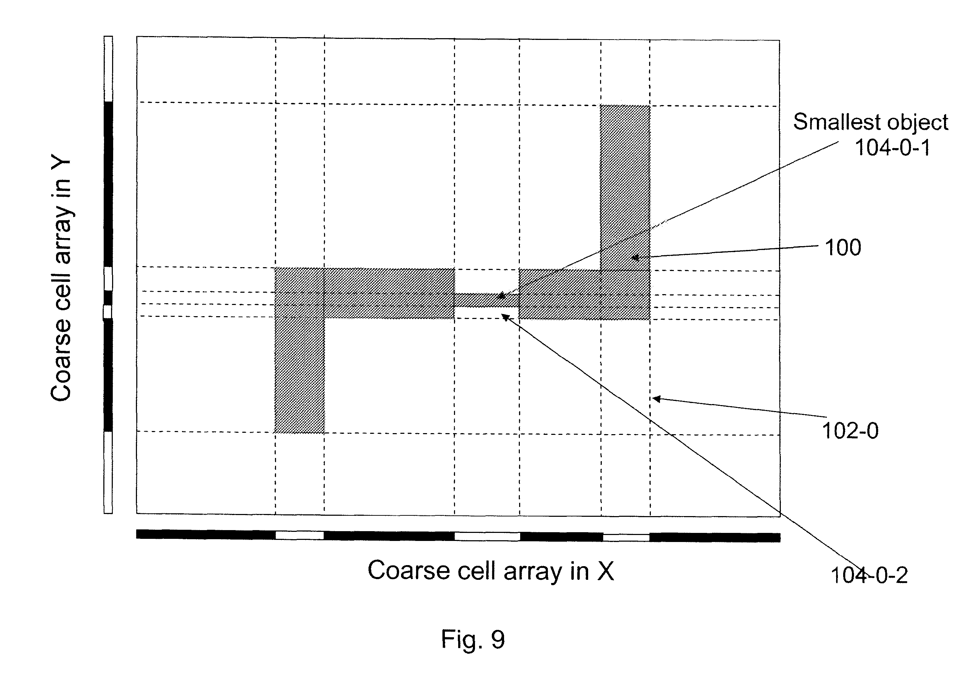

A more particular example of a method for automatic mesh and embedded mesh generation will now be described with reference to Figures 9-19.

Figure 9 shows an object 100 under consideration, which in this case is a via, for communicating signals between two sides of a circuit board. In Figure 9, stage 1 of the method has been completed, and the geometric features of the object 100 have been calculated in order to define an initial, base-level minimum FDTD mesh 102-0, the cell boundaries of which are aligned with the edges of the various geometric features of the object 100, and the smallest cell 104-0-1 in the base-level minimum FDTD mesh 102-0 has been identified.

It is to be understood that the base-level minimum FDTD mesh 102-0, and the other minimum FDTD meshes described below, are not aspects of the final FDTD scheme, but are rather constructs to be used in forming the meshes of the final FDTD scheme. This also applies to the cells of the minimum FDTD meshes, in particular the so-called combined cells referred to below.

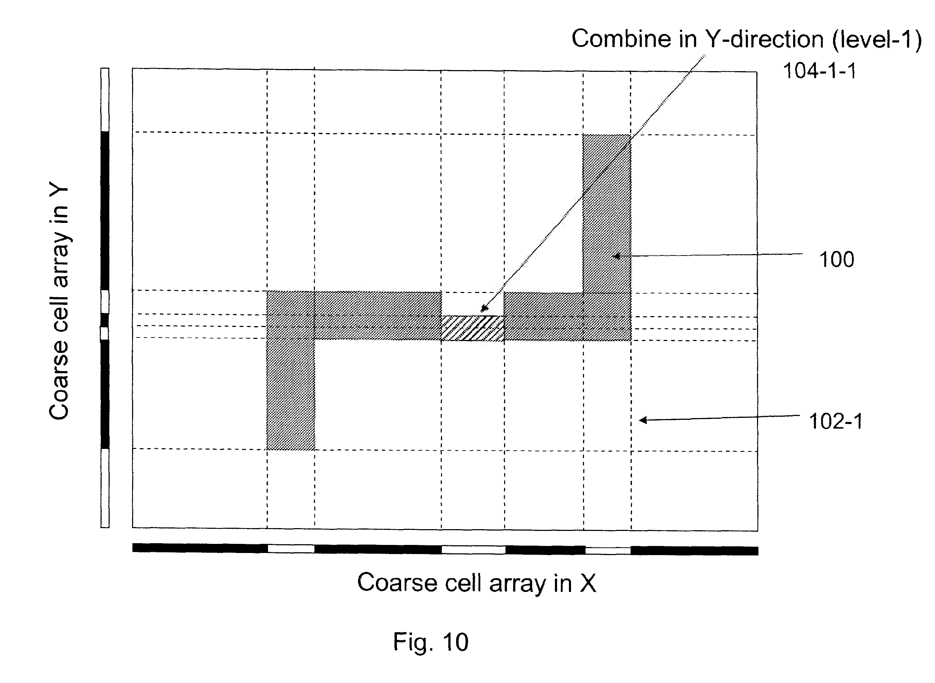

Figure 10 shows the mesh of Figure 9, after stages 2 and 3 of the method have been completed. In other words, the largest time step possible for the smallest cell 104-0-1 has been adopted for all of the cells of the base-level minimum FDTD mesh 102-0, which will ultimately correspond to the finest FDTD mesh following completion of the mesh generation process. Referring to Figures 9 and 10, the smallest cell 104-0-1 of the base-level minimum FDTD mesh 102-0 has been combined, in this case in the Y direction, with the adjacent cell 104-0-2, which is of a similar size to the smallest cell 104-0-1, to create a level-1 combined cell 104-1-1, as part of a new, level-1 minimum FDTD mesh 102-1. The adjacent cell 104-0-2 was selected by reason of it being a neighbouring cell of the smallest cell 104-0-1. The level-1 minimum FDTD mesh 102-1 will correspond to the second finest mesh of the multigrid-FDTD scheme, following the mesh generation process.

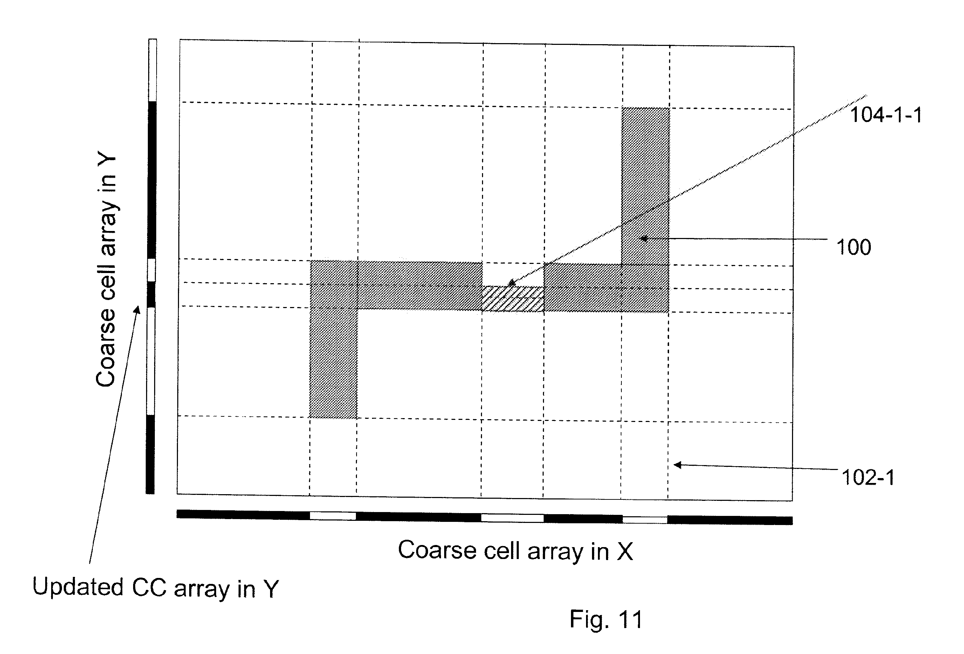

Figure 11 shows the mesh of Figure 10, after stage 4 of the method has been completed. In other words, the CC array, in this case only in the Y direction, has been updated to reflect the dimensions of the level-1 combined cell 104-1-1 in the level-1 minimum FDTD mesh 102-1.

At this point of the example, the comparison of stage 5 reveals that the mean cell size of the domain differs from the user-defined parameter by more than the predetermined threshold, since the smallest cell of the domain is still somewhat smaller than the other cells, and so the process is repeated, as detailed in the following paragraphs. Conversely, the process may be stopped if the combined cell becomes the biggest cell of the domain (in each dimension). Thus, if a combination of the smallest cell with one of its neighbouring cells has created a cell larger that the largest cell in the array in that dimension, further combination is not made in that dimension. Alternatively, the user may specify a ratio between the smallest cell and the largest cell (or average cell) size in each dimension, which, when reached, causes the process to terminate. For example the ratio may be 1:2.

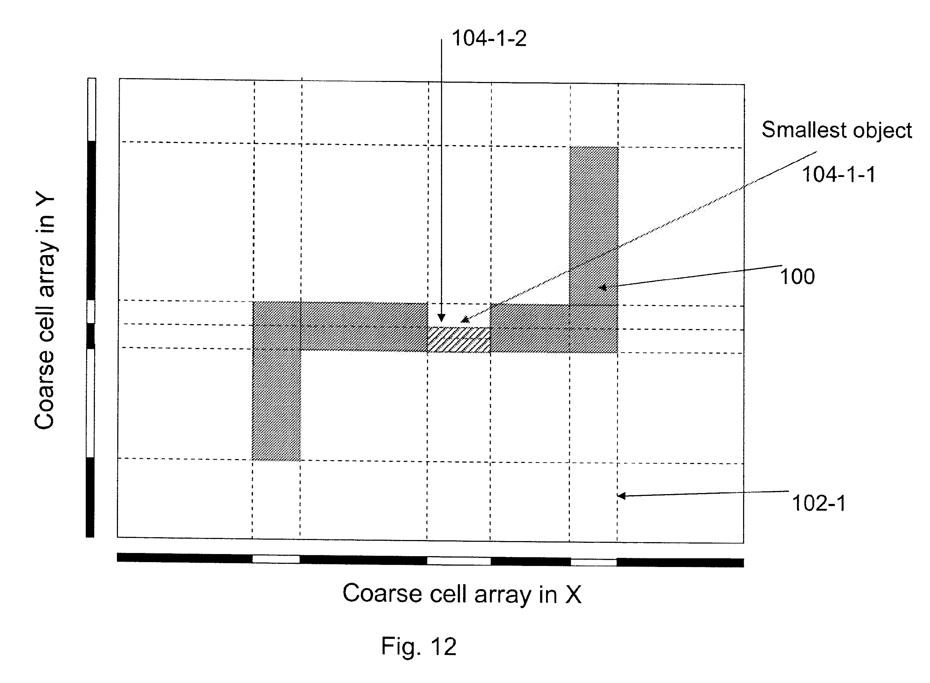

Figure 12 shows the mesh of Figure 11 after stage 1 of the repeated process, in which the level-1 combined cell 104-1-1 of the level-1 minimum FDTD mesh 102-1 is identified as being the smallest cell.

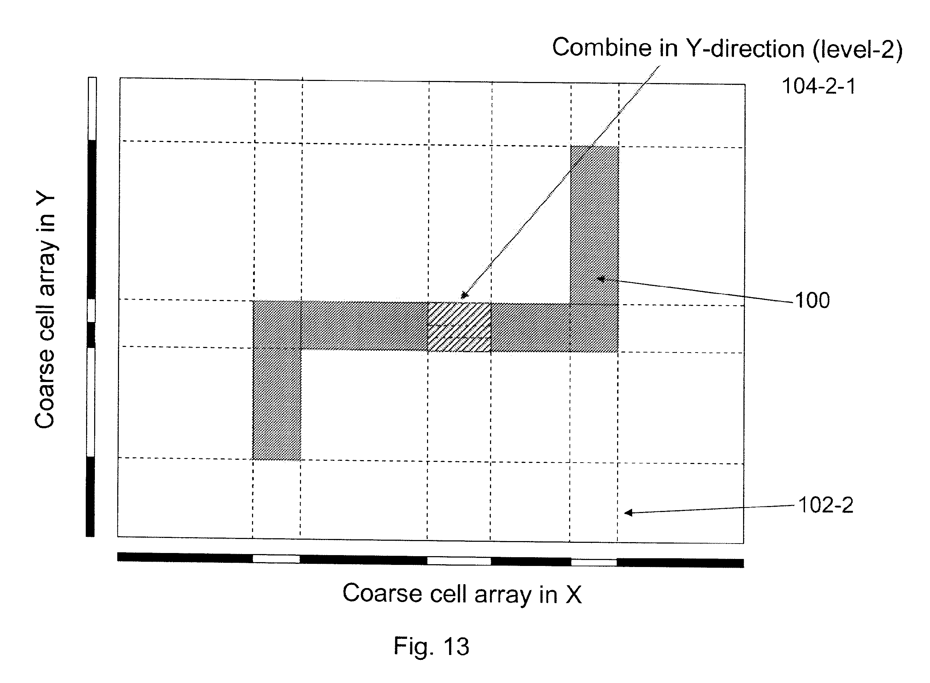

Figure 13 shows the mesh of Figure 12, after stages 2 and 3 of the repeated process have been completed. In other words, the largest time step possible for the smallest cell 104-1-1 of the level-1 minimum FDTD mesh 102-1 has been adopted for all of the cells of the level-1 minimum FDTD mesh 102-1. Referring to Figures 12 and 13, the smallest cell 104-1-1 of the level-1 minimum FDTD mesh 102-1 has been combined, in this case in the Y direction, with the adjacent cell 104-1-2, to create a level-2 combined cell 104-2-1 as part of a further, level-2 minimum FDTD mesh 102-2. The adjacent cell 104-1-2 was selected by reason of it being a neighbouring cell of the smallest cell 104-1-1. The level-2 minimum FDTD mesh 102-2 will correspond to the third finest mesh of the multigrid-FDTD scheme, following the mesh generation process.

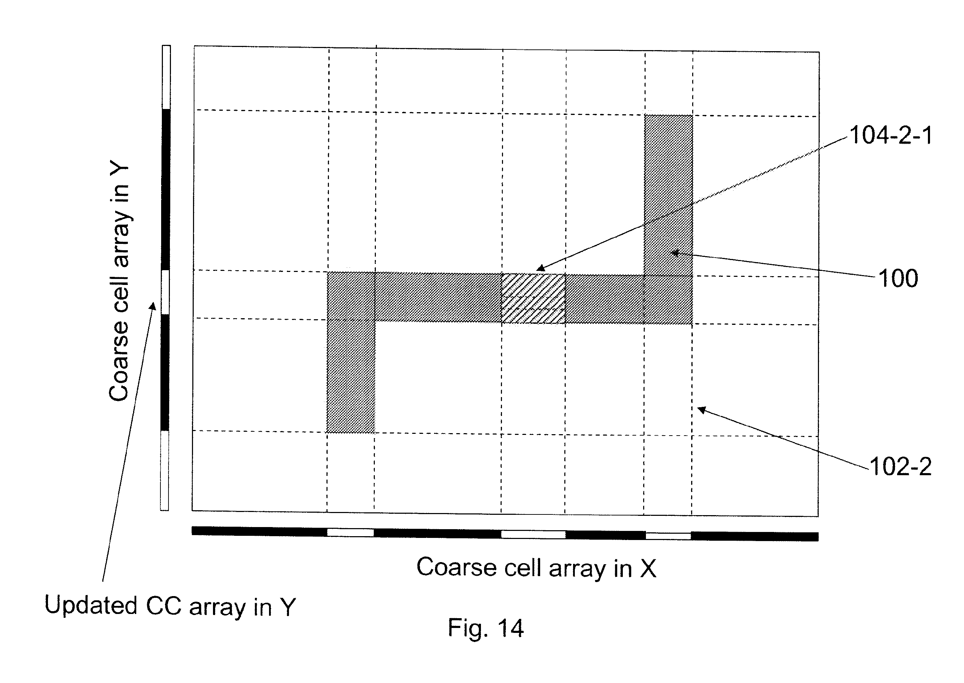

Figure 14 shows the mesh of Figure 13 after stages 4 and 5 of the repeated process have been completed. In other words, the CC array, in this case only in the Y direction, has been updated to reflect dimensions of the level-2 combined cell 104-2-1 of the level-2 minimum FDTD mesh 102-2.

At this point, the comparison of stage 5 reveals that the mean cell size of the domain differs from the user-defined parameter by less than the predetermined threshold, since the smallest cell 104-2-1 of the domain is comparable in size to the other cells, and so the process ends. The level-2 minimum FDTD mesh 102-2 thus becomes the final minimum FDTD mesh 102-2.

Thus, this process of proceeding from the smallest cell to the next smallest and enlarging the cells continues until the cells are of a similar size. This process may be performed separately for each dimension in the domain.

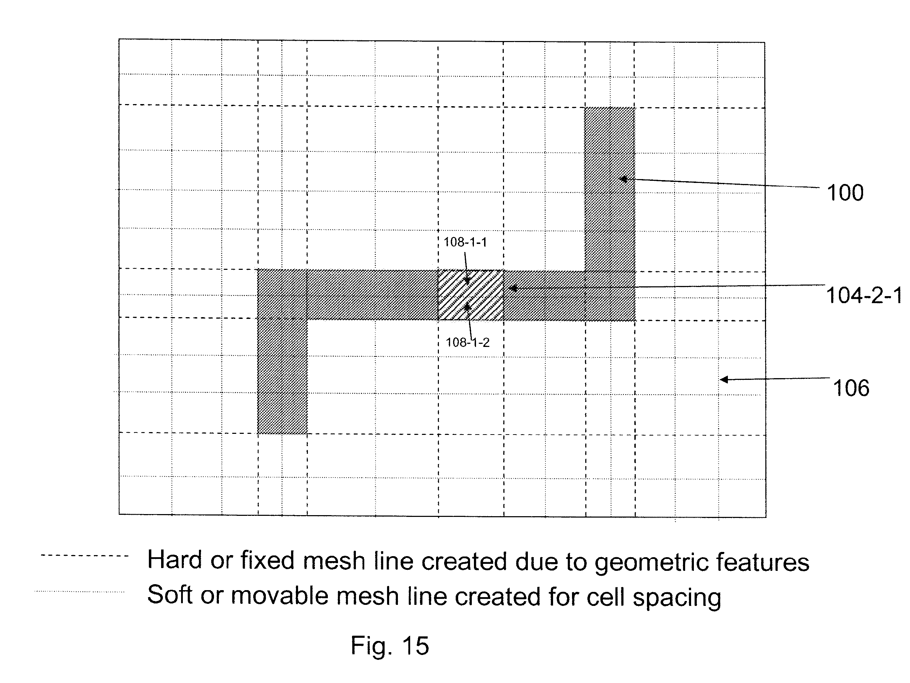

Figure 15 shows an initial FDTD mesh 106 created from the final minimum FDTD mesh 102-2. The dashed lines in Figure 15 indicate hard or fixed mesh lines created by the geometric features of the object 100, while the dotted lines indicate soft or movable mesh lines created for cell spacing. At this point, no grid embedding has taken place, such that the initial FDTD mesh 106 is the coarsest mesh of the scheme. The initial FDTD mesh 106 includes two cells 108-1-1 and 108-1-2 in the space occupied by the level-2 combined cell 104-2-1. The final combined cell 104-2-1 has been split into two in the initial FDTD mesh 106, as is standard practice in the art.

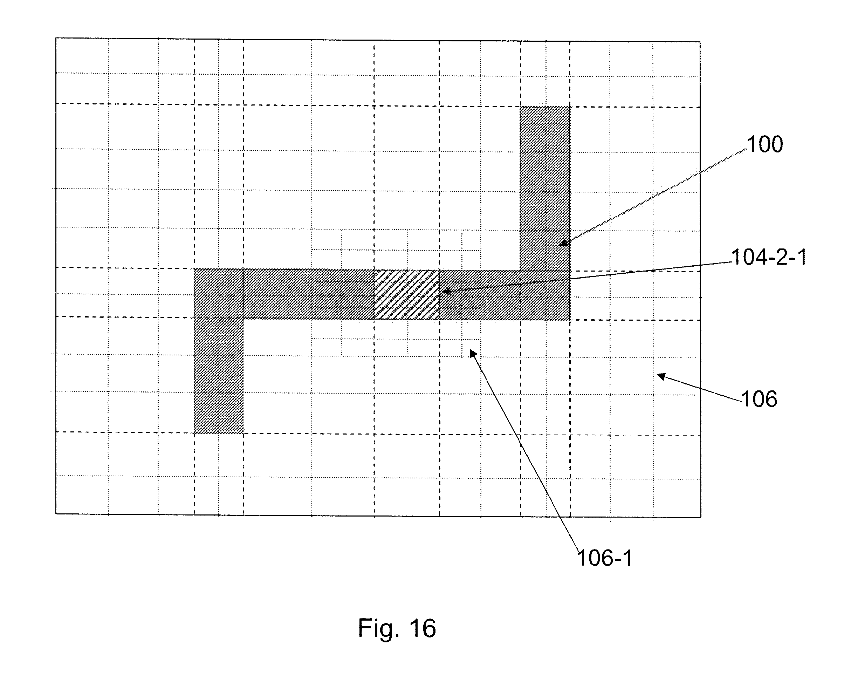

Figure 16 shows the initial FDTD mesh 106 during the first level of grid embedding. A level-1 embedded grid 106-1 has been embedded in the initial FDTD mesh 106, in the two cells 108-1-1 and 108-1-2 within the level-2 combined cell 104-2-1 and the cells immediately surrounding them. In this case, the level-1 embedded grid 106-1 refines the selected cells of the initial FDTD mesh 106 by a factor of two.

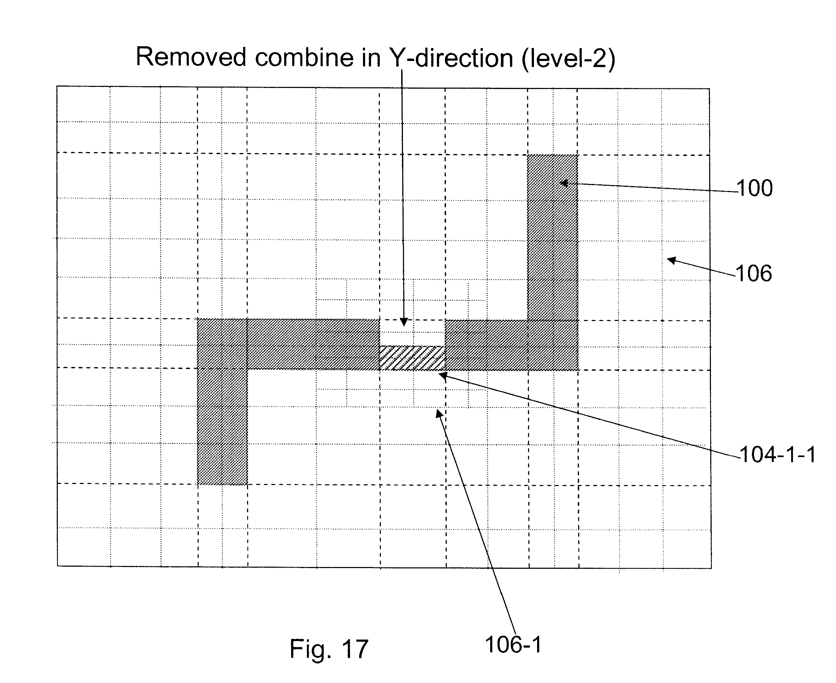

Figure 17 shows the mesh 106 of Figure 16 after the first level of grid embedding. The level-2 combined cell 104-2-1 has been removed, and the process proceeds to the level-1 combined cell 104-1-1.

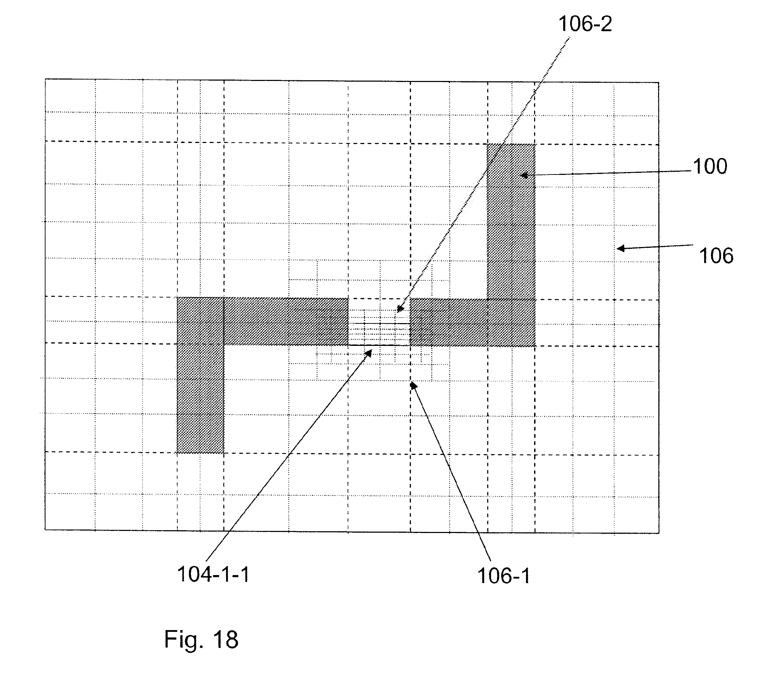

Figure 18 shows the mesh 106 of Figure 17 during the second level of grid embedding. A level-2 embedded grid 106-2 has been embedded in the level-1 embedded grid 106-1, in the cells within the level-1 combined cell 104-1-1 and the cells immediately surrounding them. In this case, the level-2 embedded grid 106-2 refines the selected cells of the level-1 embedded grid 106-1 by a factor of two.

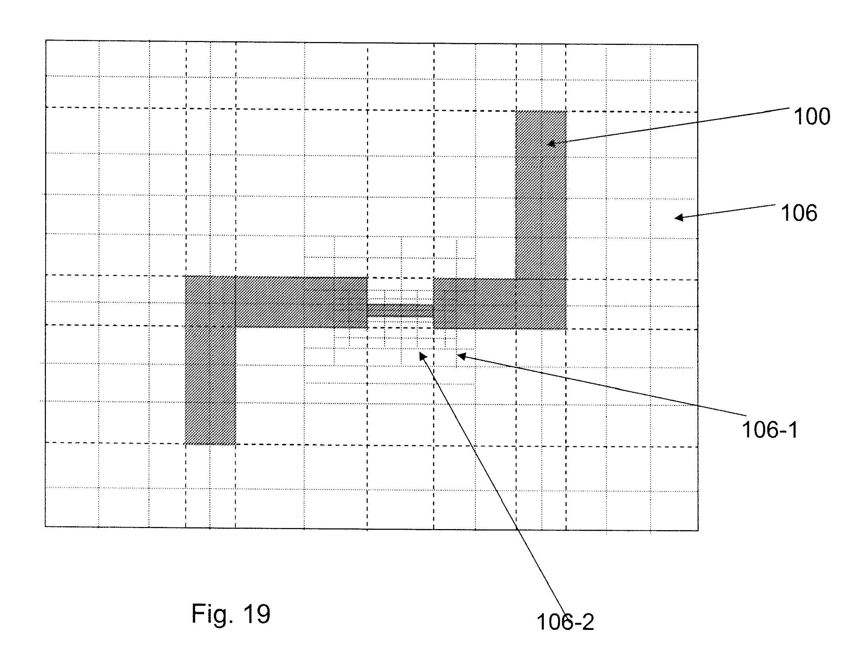

Figure 19 shows the mesh 106 of Figure 18 after the second level of grid embedding. The level-1 combined cell 104-1-1 has been removed, and the process then terminates in the absence of any further combined cells.

The initial FDTD mesh 106 uses a time step value of or about DT * 2.0. The level-1 embedded grid 106-1 uses a time step value of or about DT. The level-2 embedded grid 106-2 uses a time step value of or about DT * 0.5.

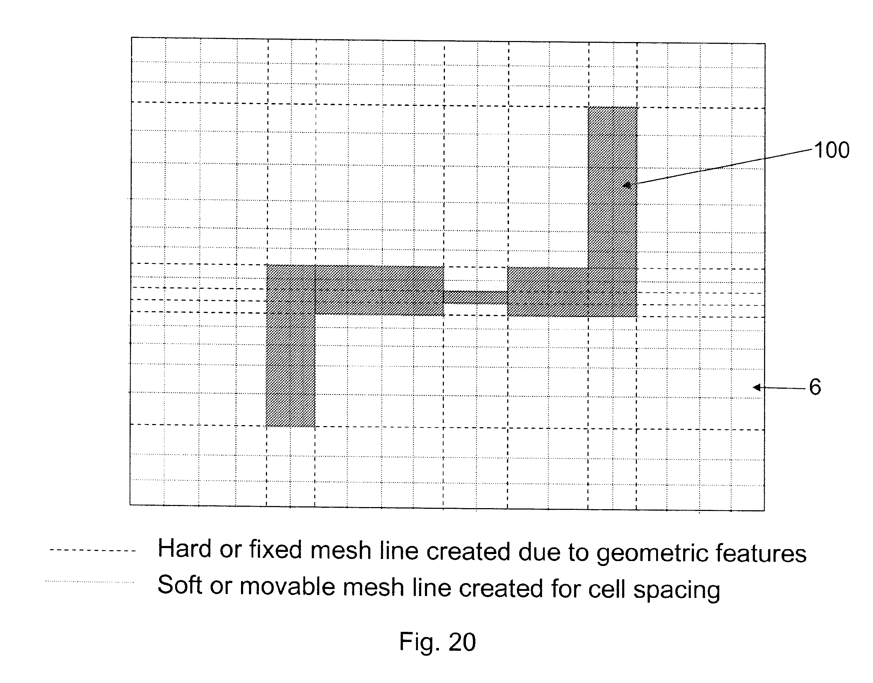

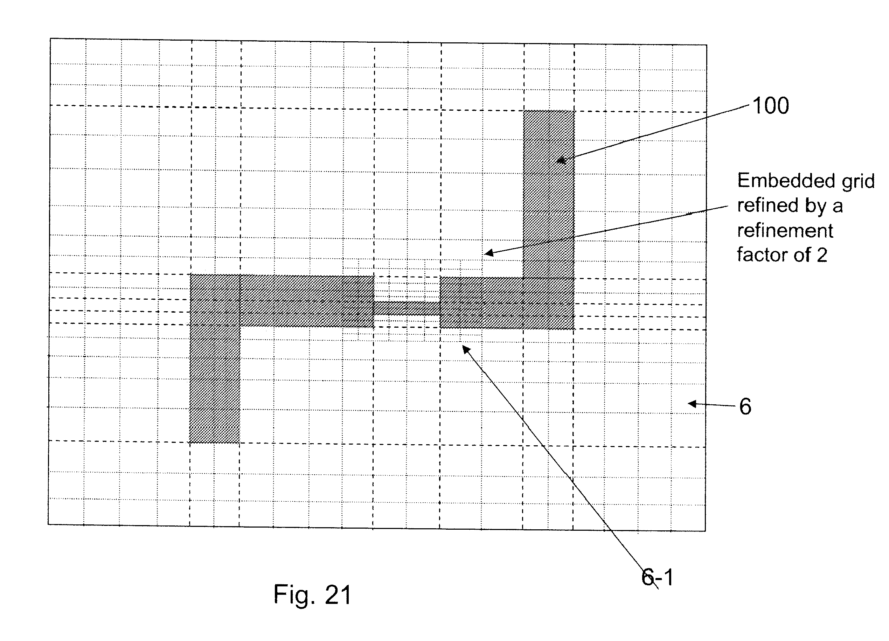

Figures 20 and 21 relate to a comparative example of mesh generation according to another method.

Figure 20 shows a base mesh 6 created to map geometric features of the object 100 to be modelled.

Figure 21 shows a level-1 embedded grid 6-1 in cells of the base mesh 6 surrounding a feature of interest of the object 100. In this case, embedding the grid 6-1 has resulted in the time step selected for the base grid 6 being halved, owing to the refinement factor of two. The time step value of all embedded grids is dependent on the base grid. Any further embedding will result in even smaller time steps for the finer grids, resulting in a longer computation time to perform the simulation.

It should be appreciated that the various aspects of the present invention may be used alone or in combination in a single embodiment.

**Claims**

1. A method for generating a multigrid domain for use in a simulation of wave propagation in a physical system, the method comprising
   generating a nested arrangement of embedded grids forming the multigrid domain by generating an initial grid having a selected time step and cell size, which initial grid is to be the finest grid in the multigrid domain, and iteratively performing the step of generating a coarser grid in which a grid generated in a previous iteration is to be embedded, starting with the initial grid, and ending with the generation of a base grid.

2. The method of claim 1, comprising identifying regions of the domain in which to embed each grid of the multigrid domain, all or part of one or more of the regions being aligned with one or more geometric features of an object to be simulated.

3. The method of claim 2, comprising selecting the time step and the cell size for the initial grid based on the largest time step permissible for the region identified for that grid.

4. The method of claim 2 or 3, comprising, during each iteration, comparing a size of a smallest cell in a said grid generated in the current iteration with sizes of other cells in the multigrid domain, and, when the sizes meet predetermined similarity criteria, terminating the iterations, for example by generating the base grid in the next iteration.

5. The method of claim 2 or 3, comprising, during each iteration, comparing the size of the generated combination of the smallest cell size with its neighbouring cell against the size of at least one other cell in the multigrid domain and, when the combination size is equal to or larger than the size of the at least one other cell, terminating the iterations, for example by generating the base grid in the next iteration.

6. The method of any of claims 2-5, comprising embedding a said grid in the region of the respective coarser grid identified for the said grid, and in cells of the coarser grid immediately surrounding the identified region.

7. The method of claim 1, comprising

   (i) analysing geometric features of an object to be simulated;
   (ii) identifying a region in which to locate the initial grid of the multigrid domain based on the geometric features of the object;
   (iii) selecting the time step and the cell size of the initial grid;
   (iv) based on the geometric features of the object, identifying a region in which to locate a said coarser grid in which the initial grid is to be embedded, the initial grid being a refinement of the said coarser grid according to a selected refinement factor;

(v) calculating a time step and a cell size of the coarser grid based on the time step and the cell size of the initial grid and the refinement factor;

(vi) repeating steps (iv) and (v) for any further said coarser grids in which a said coarser grid of a previous iteration is to be embedded, until the base grid is identified, which is not to be embedded in any other grid;

(vii) embedding each grid to be embedded in the identified region of a respective said coarser grid, to generate the nested arrangement of embedded grids forming the multigrid domain.

8. An apparatus for generating a multigrid domain for use in a simulation of wave propagation in a physical system, the apparatus comprising

generation circuitry configured to generate a nested arrangement of embedded grids forming the multigrid domain by generating an initial grid having a selected time step and cell size, which initial grid is to be the finest grid in the multigrid domain, and iteratively performing the operation of generating a coarser grid in which a grid generated in a previous iteration is to be embedded, starting with the initial grid, and ending with the generation of a base grid.

9. The apparatus of claim 8, wherein the generation circuitry is configured to identify regions of the domain in which to embed each grid of the multigrid domain, all or part of one or more of the regions being aligned with one or more geometric features of an object to be simulated.

10. The apparatus of claim 9, wherein the generation circuitry is configured to select the time step and the cell size for the initial grid based on the largest time step permissible for the region identified for that grid.

11. The apparatus of claim 8 to 10, wherein the generation circuitry is configured, during each iteration, to compare a size of a smallest cell in a said grid generated in the current iteration with sizes of other cells in the multigrid domain, and, when the sizes meet predetermined similarity criteria, to generate the base grid in the next iteration.

12. The apparatus of claim 8 to 10, wherein the generation circuitry is configured, during each iteration, to compare the size of the generated combination of the smallest cell size with its neighbouring cell against the size of at least one other cell in the multigrid domain and, when the combination size is equal to or larger than the size of the at least one other cell, to terminate the iterations, for example by generating the base grid in the next iteration.

13. The apparatus of any of claims 9-12, wherein the generation circuitry is configured to embed a said grid in the region of the respective coarser grid identified for the said grid, and in cells of the coarser grid immediately surrounding the identified region.

14. The apparatus of claim 8, wherein the generation circuitry is configured to

(i) analyse geometric features of an object to be simulated;

(ii) identify a region in which to locate the initial grid of the multigrid domain based on the geometric features of the object;

(iii) select the time step and the cell size of the initial grid;

(iv) based on the geometric features of the object, identify a region in which to locate a said coarser grid in which the initial grid is to be embedded, the initial grid being a refinement of the said coarser grid according to a selected refinement factor;

(v) calculate a time step and a cell size of the coarser grid based on the time step and the cell size of the initial grid and the refinement factor;

(vi) repeat operations (iv) and (v) for any further said coarser grids in which a said coarser grid of a previous iteration is to be embedded, until the base grid is identified, which is not to be embedded in any other grid;

(vii) embed each grid to be embedded in the identified region of a respective said coarser grid, to generate the nested arrangement of embedded grids forming the multigrid domain.

15. A computer program which, when executed on a computer, causes the computer to perform the method of any one of claims 1 to 7.

*Fig.1A*

*Fig.1B*

Fig. 2

H (n = 4.5)

E (n = 4.0)

H (n = 3.5)

E(n = 3.0)

H (n = 2.5)

E (n = 2.0)

H (n = 1.5)

E (n = 1.0)

H (n = 0.5)

E (n = 0.0)

**Fig. 3**

**Fig. 4A**

**Fig. 4B**

**Fig. 5**

Uniform FDTD    Non-uniform FDTD    Multigrid FDTD

**Fig. 6**

Stage 1

Coarse cell array in Y

Coarse cell array in X

**Fig. 7**

Stages 2 and 3

Coarse cell array in Y

Coarse cell array in X

**Fig. 8**

Fig. 9

Coarse cell array in Y

Coarse cell array in X

Smallest object
104-0-1

100

102-0

104-0-2

EP 2 287 757 A1

Fig. 10

Fig. 11

Fig. 12

Combine in Y-direction (level-2)
104-2-1

100

102-2

Coarse cell array in Y

Coarse cell array in X

Fig. 13

Coarse cell array in Y

Updated CC array in Y

Coarse cell array in X

104-2-1

100

102-2

Fig. 14

108-1-1

108-1-2

100

104-2-1

106

- - - - - - - - - Hard or fixed mesh line created due to geometric features

................ Soft or movable mesh line created for cell spacing

Fig. 15

EP 2 287 757 A1

Fig. 16

Removed combine in Y-direction (level-2)

100

106

104-1-1

106-1

Fig. 17

Fig. 18

Fig. 19

EP 2 287 757 A1

----------  Hard or fixed mesh line created due to geometric features

................  Soft or movable mesh line created for cell spacing

Fig. 20

EP 2 287 757 A1

Fig. 21

Embedded grid refined by a refinement factor of 2

100

6

6-1

EP 2 287 757 A1

Fig. 22

Fig. 23

Fig. 24

Fig. 25

**Fig. 26**

Europäisches
Patentamt

European
Patent Office

Office européen
des brevets

## EUROPEAN SEARCH REPORT

Application Number

EP 09 16 8324

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHOW P ET AL: "A multilevel subgridding approach to multiscale electromagnetic simulation" INTERNATIONAL JOURNAL FOR MULTISCALE COMPUTATIONAL ENGINEERING, US, vol. 5, no. 1, 1 January 2007 (2007-01-01), pages 19-25, XP009123513 ISSN: 1543-1649 the whole document, in particular sections 1. Introduction 2.3 Multilevel Subgridding FDTD 3.1 Model Example 1 3.2 Model Example 2 ----- | 1-15 | INV. G06F17/50 |
| A | CHAILLOU S ET AL: "A subgridding scheme based on mesh nesting for the FDTD method" MICROWAVE AND OPTICAL TECHNOLOGY LETTERS WILEY USA, vol. 22, no. 3, 5 August 1999 (1999-08-05), pages 211-214, XP002553617 ISSN: 0895-2477 the whole document, in particular sections II. Subgridding Technique III. Nested Scheme (in combination with Fig. 1) ----- -/-- | 1-15 | TECHNICAL FIELDS SEARCHED (IPC)  G06F |

The present search report has been drawn up for all claims

| Place of search | Date of completion of the search | Examiner |
|---|---|---|
| Munich | 3 November 2009 | Lerbinger, Klaus |

EPO FORM 1503 03.82 (P04C01)

| | Europäisches Patentamt | | |
|---|---|---|---|
| | European Patent Office | **EUROPEAN SEARCH REPORT** | **Application Number** |
| | Office européen des brevets | | EP 09 16 8324 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MICHAL OKONIEWSKI ET AL: "Three-Dimensional Subgridding Algorithm for FDTD" IEEE TRANSACTIONS ON ANTENNAS AND PROPAGATION, IEEE SERVICE CENTER, PISCATAWAY, NJ, US, vol. 45, no. 3, 1 March 1997 (1997-03-01), XP011002928 ISSN: 0018-926X the whole document, in particular section II. Subgridding Algorithm ----- | 1-15 | |
| A | CHOI C T M ET AL: "A New Multilevel Subgridding Scheme for Two-Dimensional FDTD Method" IEEE TRANSACTIONS ON MAGNETICS, IEEE SERVICE CENTER, NEW YORK, NY, US, vol. 40, no. 2, 1 March 2004 (2004-03-01), pages 1025-1028, XP011110795 ISSN: 0018-9464 the whole document, in particular section II. B. Multilevel FDTD Subgridding Scheme ----- | 1-15 | TECHNICAL FIELDS SEARCHED (IPC) |

The present search report has been drawn up for all claims

| Place of search | Date of completion of the search | Examiner |
|---|---|---|
| Munich | 3 November 2009 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&  : member of the same patent family, corresponding document

EPO FORM 1503 03.82 (P04C01)